# EUROPEAN PATENT SPECIFICATION

(11) **EP 2 877 864 B1**
(45) Date of publication and mention of the grant of the patent: **04.01.2017**
(21) Application number: 13774616.0
(22) Date of filing: 24.07.2013
(51) Int. Cl.: G01R 23/20, G01R 19/00, H01J 37/32

(54) **ANALYSING RF SIGNALS FROM A PLASMA SYSTEM**
ANALYSE VON HF-SIGNALEN IN EINEM PLASMASYSTEM
ANALYSE DE SIGNAUX RADIOFRÉQUENCES (RF) PROVENANT D'UN SYSTÈME PLASMA

(30) Priority: 25.07.2012 EP 12177926
(43) Date of publication of application: 03.06.2015
(73) Proprietor: Impedans Ltd, Dublin 17 (IE)
(72) Inventor: SCULLIN, Paul, Lucan County Dublin (IE); HOPKINS, Michael, 5 (IE)
(74) Representative: Brophy, David Timothy
(86) International application number: PCT/EP2013/065663
(87) International publication number: WO 2014/016357

(56) References cited:
- US-A- 5 939 886

## Description

### Technical Field

The present invention generally relates to the analysis of RF signals from plasma systems, including analysing optical signals of a plasma load modulated at RF frequencies.

### Background Art

Plasma processes are used in a wide range of industries such as the semiconductor, flat panel and solar fields. These plasma processes are required to perform complex processes such as deposition, etching or modification of a surface in real time.

The plasmas are formed by passing an RF current through a low pressure gas. The density of the plasma depends on the frequency of the RF waveform through the relationship between collision frequency and RF frequency. Relatively high frequencies are used to maximise the plasma density. Often a second frequency RF wave is used to bias the substrate being processed so that ions strike the surface with the correct energy to maximise etch rate. In recent years the structures to be etched are being reduced in dimension and more complex plasma excitation regimes are being used. Often the plasmas are generated from multiple frequencies in order to control the plasma density and energy of ions arriving at the wafer surface separately. Pulsed plasmas are also being used to better control the electron energy and quality of the etch.

The yield and overall efficiency of a plasma process is often determined by the physical geometry of the substrate holder and its environs and the plasma power source and matching. The RF impedance of the plasma and the quality of the power delivered are important factors that now need to be monitored to ensure the process is running correctly. The plasma impedance and power are complex values containing both a real and imaginary components, the measured impedance includes both the chamber and plasma impedances and because the chamber impedance often dominates over the plasma impedance very accurate measurements are required.

Directly monitoring the plasma parameters is difficult because of the problems associated with plasma disturbance and contamination arising from introducing sensors into the plasma reactors. Therefore external probes on the RF delivery path or optical probes mounted on a window are becoming more important in ensuring that the plasma is performing correctly and in supporting closed loop control of the plasma process.

Difficulties arise in the current art in that multiple frequencies are used. Typical frequencies are 400kHz, 800kHz, 2MHz, 13.56MHz, 27MHz and 40MHz. Because the plasma is a non-linear load the plasma produces harmonics which are present in the signals and confuse the sensors. Also when two frequencies are present the non-linear plasma load produces an inter-modulation between the two frequencies. These inter-modulation components also add to the complexity of the RF waveforms. In some systems the two frequencies are not fixed but can move in order to facilitate matching of the power to the load. The challenge for a diagnostic system is to isolate and measure the fundamental parameters of the plasma process such as power delivered, plasma impedance, or optical intensity in such a complex signal.

US6522121 B2 describes a method of down-converting each RF signal to a base band and analysing the signal using a quality audio digitizer. This approach creates a plurality of signals and digitizers. Such a system can become quite complex and only a limited number of signals can be monitored at any one time. The system is limited in pulsed application if the pulse frequency is of the order of, or higher than the local oscillator used to down convert the signal. Frequency tuning means that the fundamental will move and so the local oscillator must track this movement, which is not an easy solution to implement and is a drawback.

To overcome these issues an improvement has been proposed in WO2006/135515 based on sampling-based frequency converters that bring the RF voltage and current signals to a fixed intermediate frequency. However, such down converters are limited in application where there are multiple frequencies or where there is a high repetition pulse rate. Direct sampling of the RF requires that the sampler operates at twice the maximum frequency measured (referred to as the Nyquist frequency). Existing high-resolution analogue to digital converters have limited bandwidths and this creates a need for a sampling system that does not require extremely high sampling rates but avoids down conversion to an IF frequency.

The document US 5,939,886 A discloses a plasma monitoring and control method and system.

A further limitation of the existing art is the handling of noise and obtaining good signal-to-noise (S/N) ratios, especially for higher harmonics and in the presence of multiple frequency signals. The state of the current art consists of either synchronised averaging where the S/N increases with the square root of the number of measurements that are averaged. Synchronisation is possible but requires hardware isolation of the signals and a circuit to lock on the required signal. Such systems are complex to build and are not suitable for pulsed operation because of the time needed to lock to the sync signal, there are also not suitable for variable multi-frequency systems.

In the case of non-synchronous RF signals the current art provides that the signals be captured in time in samples of fixed length. A periodogram is computed from a finite-length digital sequence using the fast Fourier transform (FFT). The raw periodogram is not a good spectral estimate because of spectral bias and the fact that the variance at a given frequency does not decrease as the number of samples used in the computation increases. The spectral bias problem arises from a sharp truncation of the sequence, and can be reduced by first multiplying the finite sequence by a window function which truncates the sequence gradually rather than abruptly. Averaging periodograms does not improve S/N and leaves the interference from inter-modulation and overlapping harmonics in place. Techniques to reduce S/N such as Bartlett's method cannot be used because the complex spectral data requires that the data retain the maximum spectral frequency resolution possible.

If the sample frequency is below the highest frequency required to be measured then high frequency components will be aliased and appear in the time sequence at lower frequencies further complicating the spectrum and adding often unwanted spectral features. The state of the art normally removes this problem by adding a hardware based anti-aliasing filter on the input to the analog-to-digital converter (ADC). This reduces to the bandwidth of the system.

Thus it can be seen that the current state of the art either down converts the raw signals to an intermediate frequency and captures the data using high resolution ADC's or uses direct conversion and measures the periodogram. Both approaches are limited by the spectral complexities of the signals of interest and do not allow the reduction of variance and subsequent increase in S/N that is desired to produce reliable signals for process control in multi-frequency, variable frequency and pulsed frequency applications.

### Summary of the invention

There is provided a method of analysing RF signals from a plasma system, comprising the steps of:
(a) receiving from the plasma system one or more signal channels, wherein the or each signal channel comprises a data source representing signals and noise from the plasma system across a frequency range;
(b) identifying, in a first RF signal sample from one of said signal channel(s), a first frequency value, F, at which a local maximum is found in the frequency domain;
(c) determining a first complex frequency-domain signal component at said first frequency value, F in said first signal sample;
(d) identifying, in said first RF signal sample or in a further RF signal sample from one of said signal channel(s), a further frequency value F(N), where N is an integer representing an Nth order harmonic of said first frequency F, and wherein N = 1 for the 1st order harmonic at the first frequency F;
(e) determining a further complex frequency-domain component at said further frequency value in the RF signal sample in which said further frequency value is identified;
(f) transforming the first complex frequency-domain component by adjusting its phase by an angle θ to a predetermined phase angle ϕ, to provide a phase-adjusted first complex signal component;
(g) transforming the further complex frequency-domain component by adjusting its phase by an angle equal to N x θ, to provide a phase-adjusted further complex signal component;
(h) iteratively repeating steps (b) to (g) in respect of a plurality of signal samples from the same plasma system, wherein in each iteration the value of θ is chosen to give a constant phase angle ϕ for the phase-adjusted first complex signal component across different iterations, and wherein within any iteration the value of θ chosen in step (f) is employed in the adjustment of step (g);
(i) aggregating or averaging the phase adjusted first complex signal components obtained in each iteration;
(j) aggregating or averaging the phase-adjusted further complex signal components obtained in each iteration.

The phase shift operation essentially allows multiple periodograms to be averaged without the desired fundamental and its harmonics being reduced. Other signals which are not in phase with the fundamental voltage will add vectorally in such as way as they tend to cancel. This also includes noise, so that the variance of the signal will reduce by the square root of the number of periodograms averaged. This leads to a dramatic increase in the S/N of the averaged signal.

The first frequency F is preferably, but need not be, a fundamental frequency from the plasma system, e.g. F may be the 13.56 MHz signal often found in a plasma system. However, the first frequency could itself be a harmonic, such as the second harmonic at 27.12 MHz, in which case the value N=1 (in the phase shifting method disclosed herein) represents the 27.12 MHz signal and N=2 represents the harmonic at 54.24 MHz (which is in reality the 4th harmonic of the 13.56 fundamental).

What is important is that the first frequency is phase-adjusted by an angle θ to a predetermined phase angle ϕ, and then the or each further frequency is adjusted by an angle N x θ where N represents the frequency multiplier between the first and further frequencies.

In some embodiments, the signal channel in which the first frequency value is identified is not the same as the signal channel in which the further frequency value is identified.

Thus, one may identify a signal maximum in (say) a voltage signal channel, and use the phase shift operation on a corresponding or harmonic frequency in (say) a current or optical signal channel, with the phase shift operation allowing the current or optical periodograms to be cleaned up by reduction of noise and reinforcement of the signal component which has the correct phase relationship with the first frequency in the voltage channel.

Preferably, therefore, the signal channel in which the first frequency value is selected is one of a voltage signal channel, a current signal channel, and an optical signal channel, and the signal channel in which the further frequency value is identified is a different one of a voltage signal channel, a current signal channel, and an optical signal channel.

Preferably, on each iteration, steps (d), (e) and (g) are carried out more than once such that a plurality of further frequency values are identified in step (d) each representing a harmonic of said first frequency F found within a signal channel from the plasma system, and for each such harmonic a respective further complex frequency-domain component is determined in step (e) which is transformed in step (g) to provide a respective phase-adjusted further complex signal component, and wherein step (i) is repeated separately for each such phase adjusted further complex signal component.

In this way, identifying and isolating a signal maximum in a single signal channel allows the method to be repeated on multiple harmonic signals across different channels.

More preferably, steps (d), (e) and (g) are carried out at least once for a further frequency value identified in said first RF signal sample, and at least once for a further frequency value identified in a further RF signal sample from a different signal channel.

Preferably, the first frequency value is identified as a fundamental frequency in a voltage signal channel and at least one further frequency value is a harmonic of said fundamental frequency in said voltage signal channel of order N > 1, and further wherein another of said further frequency values is identified as a harmonic (N >= 1) of the same fundamental frequency within a signal sample from a current signal channel or an optical signal channel.

Alternatively, the first frequency value may be identified as a fundamental frequency in a current signal channel and at least one further frequency value is a harmonic of said fundamental frequency in said current signal channel of order N > 1, and further another of said further frequency values is identified as a harmonic (N >= 1) of the same fundamental frequency within a signal sample from a voltage signal channel or an optical signal channel.

Preferably, the first frequency value and plurality of further frequency values include at least the first and second order harmonics from a current signal channel and the first and second order harmonics from a voltage signal channel.

In preferred embodiments:
the step (b) of identifying a first frequency value comprises identifying a bin number *b1* of a discrete Fourier transform in which a local maximum of signal magnitude is located or expected, and
the step (d) of identifying a further frequency value comprises determining the identity of a bin number *b2* = N *x b1,* subject to modulo arithmetic where the modulus is the total number of bins, and selecting a bin which lies within N bins adjacent to bin *b2.*

Typically, one will choose a bin number *b2* which is a simple multiple, subject to modulo arithmetic. For example, if there are 512 bins, and a first frequency (N=1) is identified in bin *b1* = 204, then the second harmonic (N=2) may be identified simply as the complex signal component in *b2* = 408. Or the third harmonic (N=3) may be identified simply as the complex signal component in *b2* = 100 (i.e. 612 becomes 100 under modulo 512 arithmetic).

However, in some scenarios one will need to consider that the bin *b1* spans a finite frequency range and the actual signal peak may lie at the frequency equivalent to bin location 204.8 (which is within the frequency range covered by bin 204, but close to bin 205). In such cases, the third harmonic would be at a frequency which is equivalent to bin location 614.4 or by modulo arithmetic, within the frequency range covered by bin 102. Hence the selection of the complex frequency component for the third harmonic in this case may involve determining the identity of a bin number *b2 =* 100 as above described, but then selecting a bin (e.g. bin 102) which lies within 3 bins adjacent to bin *b2.*

The selection of a bin which lies within N bins adjacent to bin *b2* may involve identifying a bin within said range where a local maximum of signal magnitude is found.

Alternatively, and more preferably where possible, the selection of a bin which lies within N bins adjacent to bin *b2* may comprise selecting a bin in which a frequency multiple F(N) will be found where the frequency F is known with a precision greater than the bin size.

The value of the fundamental or first frequency F may drift between successive iterations and preferably, on each iteration the first frequency value F is identified as a local maximum signal within an expected frequency range.

Preferably, the method comprises the initial steps of receiving at least one RF signal sample from a signal channel and performing a transform of said at least one RF signal sample to the frequency domain.

Preferably, said transform is a discrete Fourier transform, and preferably a fast Fourier transform.

In preferred embodiments, steps (b) to (j) are repeated based on a different first frequency F', at which a local maximum is found in the frequency domain, where F' and F are not harmonics of one another.

For example, a signal analysis may be carried out in each iteration on the fundamental voltage frequency component at F = 27.12 MHz, its second and third harmonics (i.e. F(2) and F(3) within the same signal channel, and the first, second and third harmonics of the current signal for 27.12 MHz, 54.24 MHz and 81.36 MHz (i.e. F(1), F(2) and F(3) within a different signal channel). Then the entire procedure can be repeated in terms of repeating steps (b) to (j) based on (say) a 800kHz fundamental and one or more of its harmonics within voltage and/or current.

There is also provided a computer program product comprising machine-readable instructions which, when executed in a processor provided with data representative of one or more RF signals of a plasma system, are effective to carry out any of the methods herein.

The computer program product may be provided on a data carrier, or as instructions in a computer memory, or may be implemented as a hardwired circuit, or may be implemented as logical rules in a programmable circuit such as a field programmable gate array.

When implemented as programmable instructions the processor can be a processor of a general purpose computer system, or a dedicated processor such as a digital signal processor chip.

There is further provided a system for analysing RF signals from a plasma system, comprising one or more processing circuits programmed to execute any of the methods herein.

Preferably, the one or more processing circuits are implemented as a field programmable gate array and said programming of said circuits comprises configuring said field programmable gate array with a logic function implementing said method.

### Brief Description of the Drawings

Fig. 1 is a schematic diagram of a system for analysing RF signals from a plasma system;
Fig. 2 shows simulated voltage and current signals on the RF line due to a 800 kHz RF power supply and a 27.12MHz power supply;
Fig. 3 shows the results of a fast Fourier transform on the current signal of Fig. 2;
Fig. 4 shows a close-up of the 800kHz peak and associated harmonics;
Fig. 5 shows the data from a range of frequency bins around first to fifth harmonic peaks of a 800kHz signal for voltage and current signals, both before and after application of the method of the invention;
Fig. 6 shows datasets arranged as in Fig. 5 but with the addition of noise; and
Fig. 7 shows equivalent datasets to Fig. 5, arranged as in Fig. 5, but for the first to fifth peaks of a 27.12MHz signal, with noise.

### Detailed Description of Preferred Embodiments

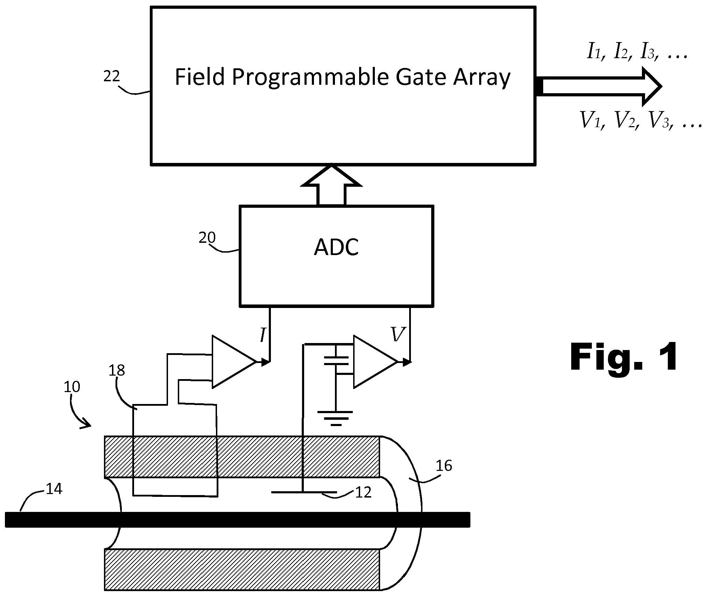

As seen in Fig. 1, the RF sensor indicated at 10 consists of a broadband capacitive voltage pick-up 12 to capture the voltage on an RF line 14 connected to the plasma electrode. The broadband capacitive voltage pick-up 12 is designed to have a flat frequency response over the frequency range of interest. The sensor 10 also has a current loop 18 to capture the RF current in the RF line connected to the plasma. The RF loop is designed to operate in a transformer mode so that it essentially has a flat frequency response over the frequency range of interest. The voltage 12 and current 18 pick-ups are embedded in a power transmission line 16 surrounding the RF line 14.

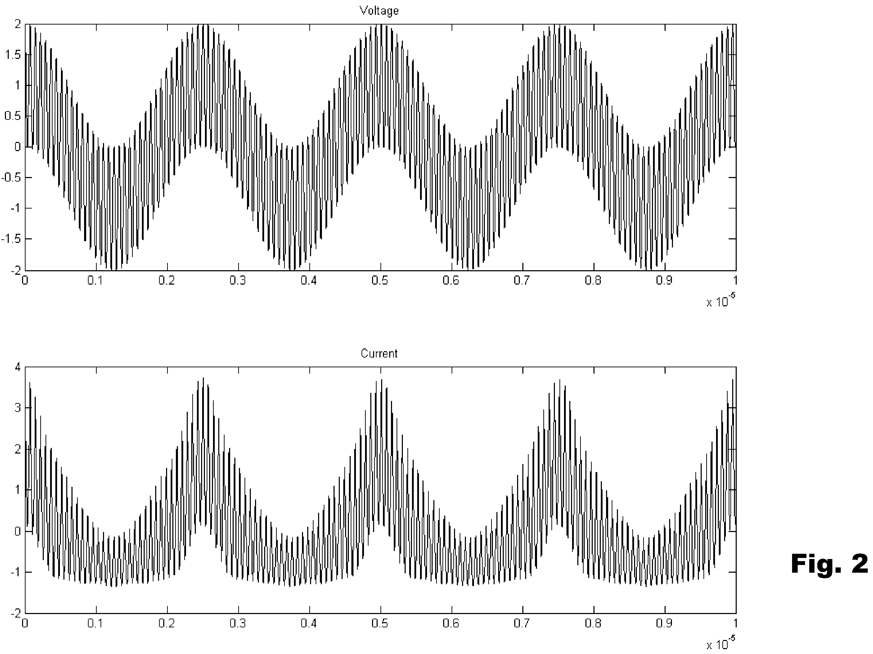

The current and voltage signals are passed from the capacitive pick up and current loop respectively to an analog-to-digital converter 20, and the digitised signals are processed in a field programmable gate array 22 as described below with reference to Fig. 2.

For this example we will refer to the RF sensor, but we also envisage an optical sensor monitoring optical data at the RF frequencies or other sensors that record useful information in the RF spectral region.

In Fig. 2, we show the simulated voltage and current signal on the RF line due to a 800 kHz RF power supply and a 27.12 MHz power supply. The voltage and current signals from the sensor are fed to a voltage and current ADC (Fig. 1) where the V and I signals are converted to a high resolution digital word (16bit) at a fixed sample rate greater than the highest fundamental frequency (27.12MHz) such as approximately 50MSPS (million samples per second) this can be achieved using a low cost digitiser. It is preferred not to use an anti-aliasing filter and that the signal bandwidth of the digitizer should be at least 5 times the Nyquist frequency (> 150MHz).

We then obtain a standard N = 512 FFT of both the of the voltage and current signals. This is achieved using a Field Programmable Gate Array chip. The 512 samples require 17.4us to acquire and about 50us to complete the FFT. Because the plasma load in non-linear there is significant harmonic distortion of the current, in particular. The non-linear load also leads to an inter-modulation of the two frequencies and a significant inter-modulation component which is again more pronounced in the current signal.

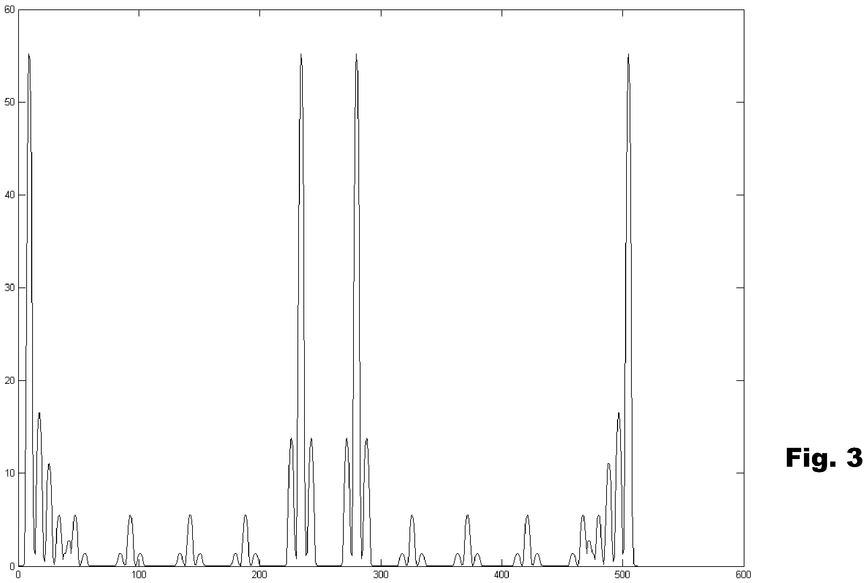

Fig. 3, shows the FFT of the simulated current signal. Here we see the fundamental 800kHz signal with magnitude 1 and the 27.12MHz with magnitude 1. In the simulated data the harmonics of the 27.12MHz signal are set to 10% of the magnitude of the fundamental and will appear at 54.24 MHz, 81.36MHz, 108.48MHz and 135.6MHz. Because of the aliasing of the digitizer running at 49.5MSPS the harmonics of 27.12 appear within the range 0-25MHz. The non-linear load will produce an inter-modulation signal at +/- 800kHz distance from the 27.12MHz and its aliases. These are clearly seen in Fig. 3.

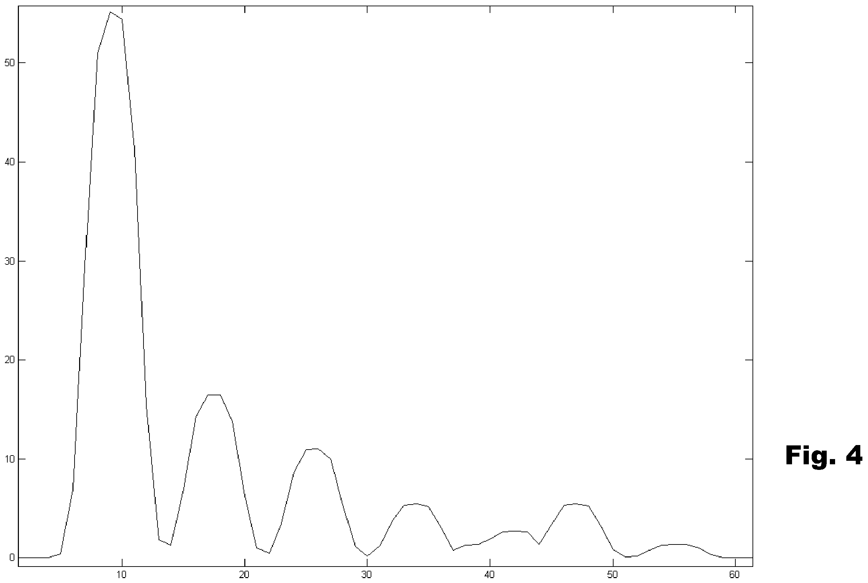

The 800kHz fundamental will also be distorted by the non-linear load and harmonics will appear at 1.6MHz, 2.4MHz, 3.2MHz and 4MHz. The amplitudes of the 800kHz harmonics were set in the simulation at 30%, 20%, 10%, and 5% of the fundamental magnitude respectfully. Fig. 4 shows a close-up of the 800kHz peak and associated harmonics. The 2^{nd} harmonic of the 27.12MHz signal is aliased and appears at 4.8MHz and its inter-modulation peaks appear at 4MHz and at 5.6MHz. It is clear that the 13.56MHz harmonics and inter-modulation products corrupt the 5^{th} harmonic and make its measurement impossible with the standard state of the art. Noise will also contribute to the uncertainty in the measurement of the peak values and will limit the ability of this approach to accurately establish the phase of any of the signals.

To overcome these limitations the present invention allows the user to select a frequency range in which the first signal is expected, say F1 = 27.56 +/- 0.5MHz and a second range in which a second frequency may be found, say F2 = 800kHz +/-100kHz. Further frequency ranges may be selected if required for multi-frequency applications. The FFT bin size in the current example is 97kHz. If the range is greater than the bin size then the signal may be found in one of several bins. The range of frequencies is needed in applications where the frequency is variable to aid matching the power to the plasma load.

The algorithm calculates the range of bins in which the fundamental component of the F1 component of signal can be found. It determines the bin where the maximum voltage signal resides and assumes this is the fundamental F1, the algorithm then rotates the voltage vector in this bin through a phase angle θ until the imaginary component of that bin goes to a predetermined phase angle ϕ. For convenience ϕ is preferably set to zero as this eliminates the imaginary component of the phase-adjusted first frequency component. The algorithm also rotates the current vector of the equivalent frequency bin of the current FFT through the same angle θ. The real component of the voltage vector is stored as Vₘ₁₁ and the new current vector Iₘ₁₁(real,imaginary) for the equivalent frequency bin is stored. The algorithm calculates the range of bins where the second m12 - n12, third m13-n13 and higher harmonics will lie. It looks for aliased signals at the appropriate part of the spectrum and rotates each voltage vector and current vector by the twice the angle (i.e. 2θ) for the second harmonic and three times the angle (3θ) for the third harmonic etc. and stores the complex vectors. The procedure is repeated for F2 and its harmonics. In reality, the bins selected may not be unique and harmonics from two frequencies may overlap and the selected bins may contain noise, other harmonics and inter-modulation components. Once all the relevant vector values are stored the remaining unused bins are discarded.

A new data set is collected and the FFT is obtained and the procedure is repeated a number of times, say 1000 times. For each such data set, the rotation angle θ is varied such that the fundamental voltage component of F1 is rotated to the same phase angle ϕ as for the first data set, and then, for each further frequency component in that data set (e.g. 2^{nd}, 3^{rd}, etc. voltage harmonics and 1^{st}, 2^{nd}, 3^{rd} current harmonics) this new rotation angle θ or a multiple Nθ thereof is employed to rotate the vector in question. This requires about 67ms in the current example. The voltage and current vectors are added to produce a time averaged periodogram. It will be appreciated that in this example, if a value of ϕ = zero was employed in the first iteration, then all of the vectors for the 1000 N=1 voltage components will have been rotated to a phase angle zero, with a different rotation angle θ being required for each data set. Each of the 1000 N = 1 current components is individually rotated by the same angle θ as its counterpart voltage vector. Each of the 1000 3^{rd} harmonic voltage vectors will have been rotated by three times the rotation angle used for the fundamental voltage vector, as will each of the 1000 3^{rd} harmonic current vectors, again preserving a constant phase difference between the voltage and current.

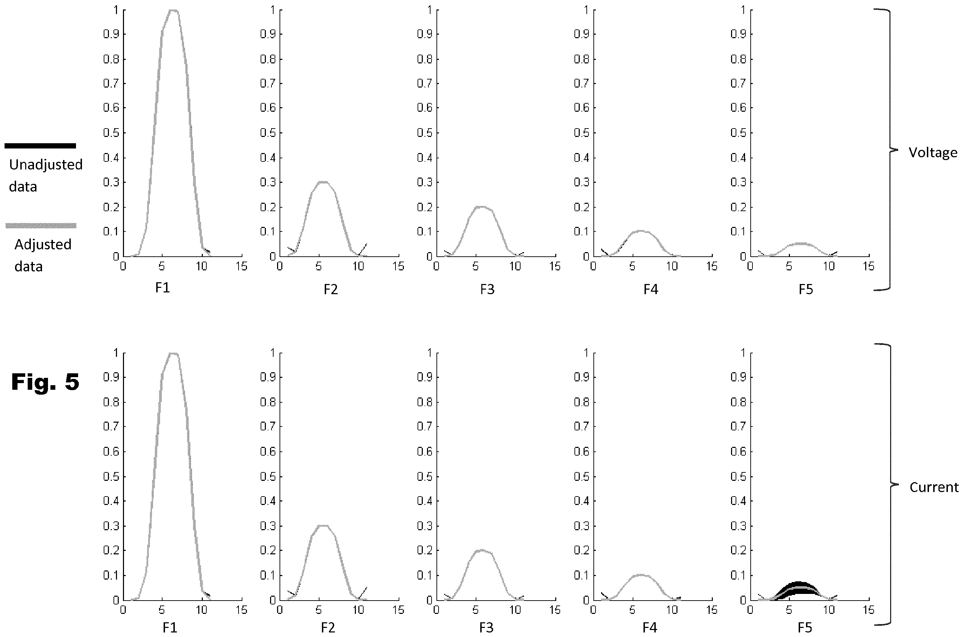

Fig. 5 shows an example of the algorithm applied to the simulated data of Fig. 2. The black line in each graph is the magnitude of the vector for voltage (top five graphs) or current (bottom five graphs) for a range of frequency bins around each harmonic from F1 to F5 (moving from left to right). The grey line in each graph is the result of applying the phase shift algorithm and averaging over 1000 periodograms. The grey line overlays the black line and conceals it where they coincide.

In the case with the 5^{th} harmonic of the current we see a blue signal that represents an inter-modulation component of the current signal at 54.24MHz aliased to appear close to the 5^{th} harmonic of the 800kHz of the current. The red line is the 5^{th} harmonic of the 800kHz averaged over a 1000 periodograms with the voltage phase shift algorithm applied. The vector magnitude is now 0.05 which is the correct value with the inter-modulation components removed.

The voltage phase shift operation applied to fundamental and harmonics essentially allows multiple periodograms to be averaged without the desired fundamental and its harmonics being reduced. The operation also preserves the phase difference between the voltage and current. A true representation of the RF waveform can also be obtained. Other signals which are not in phase with the fundamental voltage will add vectorally in such as way as they tend to cancel. This also includes noise, so that the variance of the signal will reduce by the square root of the number of periodograms averaged. This leads to a dramatic increase in the S/N of the averaged signal.

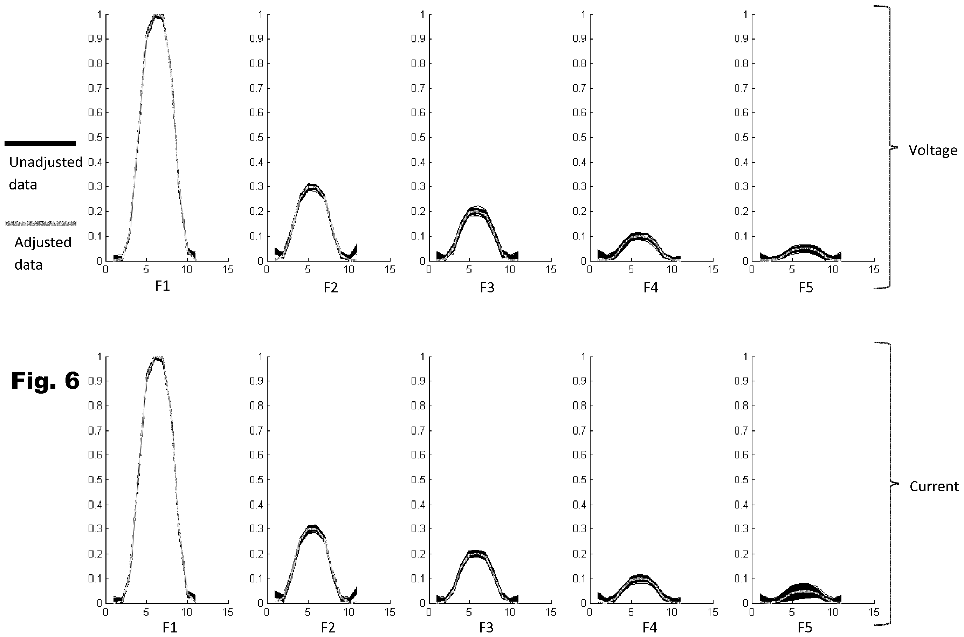

In Fig. 6 we see datasets for 800 kHz arranged in the same manner as in Fig. 5 but with noise added. In Fig. 6 each harmonic (N = 2, 3, 4, etc.) is set to be 10% of the magnitude of the fundamental (N = 1). The number of periodograms averaged is set 100 as simulation was much slower with noise added. One can see that the red line, showing the data after applying the phase adjustment algorithm and averaging is far cleaner than the blue line (pre-processing).

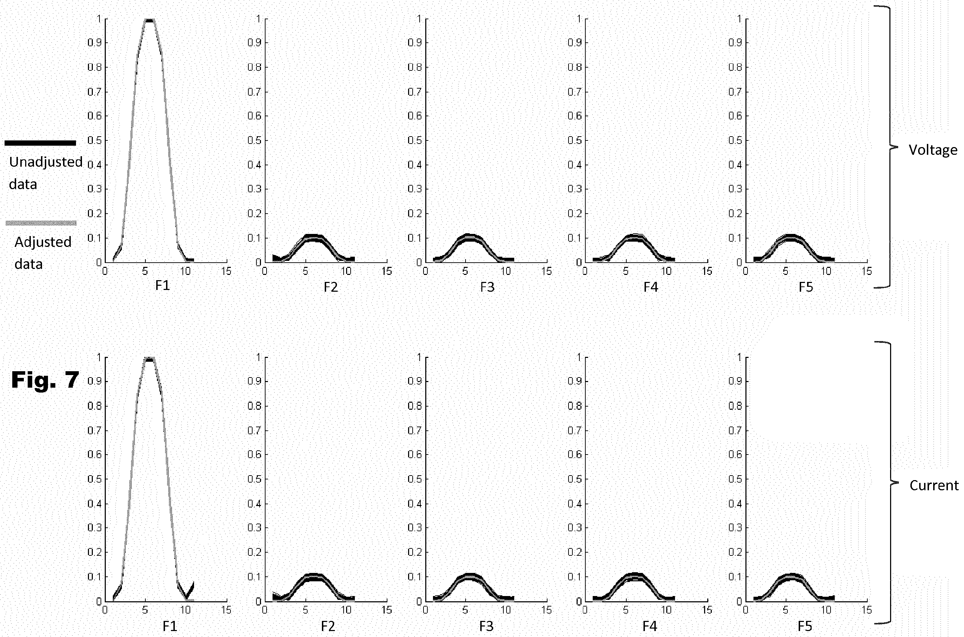

Fig. 7 shows the equivalent datasets to Fig. 5, but (a) for the 27.12MHz fundamental and its harmonics, and (b) with noise added. Again it can be seen that the effect of the algorithm is to reduce and remove spurious signals overlying the frequency components of interest, and to reduce noise dramatically.

The current techniques does not require a lock-in period, the coherence length is determined by the time taken to capture the 512 data points and is reduced somewhat by the window function. However, if synchronisation is required to further improve performance it is possible by recording the phase shift required for each fundamental voltage. For a fixed frequency sampling frequency and fixed frequency fundamentals this phase will be constant from one sample to the next. So averaging the phase shift over a period on x seconds and using the average phase is equivalent to phase locking the measured voltage and current measurement with a bandwidth determined by the length of time used to average the phase. This approach would improve the quality of data but would be difficult to use where the frequency will shift quickly or in pulsed applications.

Some examples of how the invention may operate as regards the first frequency (which sets the value of the phase adjustment angle θ) and the further frequencies (against which an adjustment of Nθ is applied) would include the following. In the following it is to be understood that "signal channel A" represents one channel containing an RF signal (such as a voltage, current or optical signal channel) and "signal channel B" represents a different channel but also containing an RF signal, and that both signal channels A and B include frequency components sharing a common fundamental frequency. (Alternatively, and less commonly, signal channels A and B might both be voltage signals but covering different parts of the spectrum in which different harmonic peaks are located).

Most commonly, signal channels A and B will broadly cover the same range of frequencies and will contain each of the harmonic peaks of interest for a given signal (e.g. when studying an 800kHz plasma RF modulation signal channel A might be a voltage signal having a bandwidth from 0 to 5MHz and signal channel B a current signal with the same bandwidth, so that the fundamental and the 2^{nd} to 6^{th} harmonics of both current and voltage are captured. Less commonly, but also within the scope and ability of this method, signal channel A might be a voltage signal covering a narrow bandwidth around (say) an 800kHz fundamental signal peak, while signal channel B might be a current signal channel containing frequencies from 1.5 to 1.7 MHz (and thus containing only the 2^{nd} harmonic frequency component of the equivalent current signal).

### Scenario 1:

First frequency is a true fundamental component from signal channel A
(i) further frequency is a higher harmonic (N = 2, 3, etc. representing 2^{nd} order, 3^{rd} order harmonic etc.) from signal channel A
(ii) further frequency is equivalent fundamental (N =1) from signal channel B
(iii) further frequency is a higher harmonic (N = 2, 3, etc. representing 2^{nd} order, 3^{rd} order harmonic etc.) from signal channel B

### Scenario 2:

First frequency is e.g. a second harmonic of a fundamental plasma frequency from signal channel A
(i) further frequency is a harmonic multiple (N = 2, 3, etc. representing 4^{th} order, 6^{th} order harmonic etc.) from signal channel A
(ii) further frequency is equivalent signal (N = 1 representing the second harmonic) from signal channel B
(iii) further frequency is a higher harmonic (N = 2, 3, etc. representing 4^{th} order, 6^{th} order harmonic etc.) from signal channel B

It can be seen that the "first frequency" is always assigned the number N = 1 and each further frequency is assigned a corresponding number N = 1, 2, 3 etc. depending on whether it is the same frequency as the first frequency (i.e. a first order harmonic thereof with N = 1), double the frequency (2^{nd} order, N = 2), triple the frequency (3^{rd} order, N = 3), etc. The first frequency at N = 1 is usually but not necessarily an actual fundamental frequency found within the signal channel, as in Scenario 1. However, Scenario 2 indicates that in some cases the first frequency, assigned N = 1, could be e.g. a 54.24MHz peak, which in reality is a second order harmonic of a 27.12MHz excitation frequency for the plasma system. In such a case, the 54.24MHz signal will be rotated by an angle θ, as will any equivalent 54.24MHz frequency components in other signal channels. N = 2 will denote any frequency components at 108.48 MHz (which are 4^{th} order harmonics of the base 27.12 MHz excitation) and these components will be rotated by 2θ, and so on.

## Claims

1. A method of analysing RF signals from a plasma system, comprising the steps of:
(a) receiving from the plasma system one or more signal channels, wherein the or each signal channel comprises a data source representing signals and noise from the plasma system across a frequency range;
(b) identifying, in a first RF signal sample from one of said signal channel(s), a first frequency value, F, at which a local maximum is found in the frequency domain;
(c) determining a first complex frequency-domain signal component at said first frequency value, F in said first signal sample;
(d) identifying, in said first RF signal sample or in a further RF signal sample from one of said signal channel(s), a further frequency value F(N), where N is an integer representing an Nth order harmonic of said first frequency F, and wherein N = 1 denotes a 1st order harmonic at the first frequency F;
(e) determining a further complex frequency-domain component at said further frequency value in the RF signal sample in which said further frequency value is identified;
(f) transforming the first complex frequency-domain component by adjusting its phase by an angle θ to a predetermined phase angle ϕ, to provide a phase-adjusted first complex signal component;
(g) transforming the further complex frequency-domain component by adjusting its phase by an angle equal to N x θ, to provide a phase-adjusted further complex signal component;
(h) iteratively repeating steps (b) to (g) in respect of a plurality of signal samples from the same plasma system, wherein in each iteration the value of θ is chosen to give a constant phase angle ϕ for the phase-adjusted first complex signal component across different iterations, and wherein within any iteration the value of θ chosen in step (f) is employed in the adjustment of step (g);
(i) aggregating or averaging the phase adjusted first complex signal components obtained in each iteration;
(j) aggregating or averaging the phase-adjusted further complex signal components obtained in each iteration.

2. The method of claim 1 wherein the signal channel in which the first frequency value is identified is not the same as the signal channel in which the further frequency value is identified.

3. The method of claim 1 or 2, in which the signal channel in which the first frequency value is selected is one of a voltage signal channel, a current signal channel, and an optical signal channel, and the signal channel in which the further frequency value is identified is a different one of a of a voltage signal channel, a current signal channel, and an optical signal channel.

4. The method of any of claims 1-3, wherein on each iteration, steps (d), (e) and (g) are carried out more than once such that a plurality of further frequency values are identified in step (d) each representing a harmonic of said first frequency F found within a signal channel from the plasma system, and for each such harmonic a respective further complex frequency-domain component is determined in step (e) which is transformed in step (g) to provide a respective phase-adjusted further complex signal component, and wherein step (i) is repeated separately for each such phase adjusted further complex signal component.

5. The method of claim 4, wherein on each iteration, steps (d), (e) and (g) are carried out at least once for a further frequency value identified in said first RF signal sample, and at least once for a further frequency value identified in a further RF signal sample from a different signal channel.

6. The method of claim 5, wherein the first frequency value is identified as a fundamental frequency in a voltage signal channel and wherein at least one further frequency value is a harmonic of said fundamental frequency in said voltage signal channel of order N > 1, and further wherein another of said further frequency values is identified as a harmonic (N >= 1) of the same fundamental frequency within a signal sample from a current signal channel or an optical signal channel.

7. The method of claim 5, wherein the first frequency value is identified as a fundamental frequency in a current signal channel and wherein at least one further frequency value is a harmonic of said fundamental frequency in said current signal channel of order N > 1, and further wherein another of said further frequency values is identified as a harmonic (N >= 1) of the same fundamental frequency within a signal sample from a voltage signal channel or an optical signal channel.

8. The method of claim 6 or 7, wherein the first frequency value and plurality of further frequency values include at least the first and second order harmonics from a current signal channel and the first and second order harmonics from a voltage signal channel.

9. The method of any preceding claim, wherein:
the step (b) of identifying a first frequency value comprises identifying a bin number *b1* of a discrete Fourier transform in which a local maximum of signal magnitude is located or expected, and
the step (d) of identifying a further frequency value comprises determining the identity of a bin number *b2* = N x *b1,* subject to modulo arithmetic where the modulus is the total number of bins, and selecting a bin which lies within N bins adjacent to bin *b2.*

10. The method of claim 9, wherein the selection of a bin which lies within N bins adjacent to bin *b2* comprises identifying a bin within said range where a local maximum of signal magnitude is found.

11. The method of claim 9, wherein the selection of a bin which lies within N bins adjacent to bin *b2* comprises selecting a bin in which a frequency multiple F(N) will be found where the frequency F is known with a precision greater than the bin size.

12. The method of any preceding claim wherein the value of the first frequency F drifts between successive iterations and wherein on each iteration the first frequency value F is identified as a local maximum signal within an expected frequency range.

13. The method of any preceding claim, further comprising the initial steps of receiving at least one RF signal sample from a signal channel and performing a transform of said at least one RF signal sample to the frequency domain.

14. The method of claim 13, wherein said transform is a discrete Fourier transform, and preferably a fast Fourier transform.

15. The method of any preceding claim, wherein steps (b) to (j) are repeated based on a different first frequency F', at which a local maximum is found in the frequency domain, where F' and F are not harmonics of one another.

16. A computer program product comprising machine-readable instructions which, when executed in a processor provided with data representative of one or more RF signals of a plasma system, are effective to carry out the method of any of claims 1-15.

17. A system for analysing RF signals from a plasma system, comprising one or more processing circuits programmed to execute the method of any of claims 1-15.

18. The system of claim 16, wherein said one or more processing circuits are implemented as a field programmable gate array and wherein said programming of said circuits comprises configuring said field programmable gate array with a logic function implementing said method.

## Patentansprüche

1. Verfahren zum Analysieren von HF-Signalen in einem Plasmasystem, das die folgenden Schritte umfasst:
(a) Empfangen eines oder mehrerer Signalkanäle vom Plasmasystem, wobei der oder jeder Signalkanal eine Datenquelle umfasst, die Signale und Geräusche vom Plasmasystem über einen Frequenzbereich hinweg darstellt;
(b) Ermitteln eines ersten Frequenzwertes, F, in einer ersten HF-Signalabtastung von dem einen Signalkanal / von einem der Signalkanäle, bei dem ein lokales Maximum im Frequenzbereich auftritt;
(c) Bestimmen einer ersten komplexen Frequenzbereichssignalkomponente bei dem ersten Frequenzwert F bei der ersten Signalabtastung;
(d) Ermitteln eines weiteren Frequenzwerts F(N) bei der ersten HF-Signalabtastung oder bei einer weiteren HF-Signalabtastung von dem einen Signalkanal / von einem der Signalkanäle, wobei N eine ganze Zahl ist, die eine Harmonische N-ter Ordnung der ersten Frequenz F darstellt, und wobei N = 1 eine Harmonische erster Ordnung bei dieser Frequenz F bedeutet;
(e) Bestimmen einer weiteren komplexen Frequenzbereichskomponente bei dem weiteren Frequenzwert bei der HF-Signalabtastung, bei der der weitere Frequenzwert ermittelt ist;
(f) Transformieren der ersten komplexen Frequenzbereichskomponente durch Verstellen ihrer Phase um einen Winkel θ auf einen vorbestimmten Phasenwinkel ϕ, um eine phasenverstellte erste komplexe Signalkomponente bereitzustellen;
(g) Transformieren der weiteren komplexen Frequenzbereichskomponente durch Verstellen ihrer Phase um einen zu N x θ äquivalenten Winkel, um eine weitere phasenverstellte komplexe Signalkomponente bereitzustellen;
(h) iteratives Wiederholen der Schritte (b) bis (g) in Bezug auf eine Vielzahl von Signalabtastungen von demselben Plasmasystem, wobei bei jeder Iteration der Wert von θ gewählt wird, um einen konstanten Phasenwinkel ϕ für die phasenverschobene erste komplexe Signalkomponente über verschiede Iterationen hinweg zu ergeben, und wobei innerhalb jeder Iteration der im Schritt (f) gewählte Wert von θ in der Verstellung des Schritts (g) verwendet wird;
(i) Zusammenfassen oder Mitteln der ersten phasenverstellten komplexen Signalkomponenten, die in jeder Iteration erhalten wurden;
(j) Zusammenfassen oder Mitteln der weiteren phasenverstellten komplexen Signalkomponenten, die in jeder Iteration erhalten wurden.

2. Verfahren nach Anspruch 1, wobei der Signalkanal, bei dem der erste Frequenzwert ermittelt wird, nicht derselbe ist wie der Signalkanal, bei dem der weitere Frequenzwert ermittelt wird.

3. Verfahren nach Anspruch 1 oder 2, bei dem der Signalkanal, bei dem der erste Frequenzwert ausgewählt wird, einer von einem Spannungssignalkanal, einem Stromsignalkanal und einem optischen Signalkanal ist, und der Signalkanal, bei dem der weitere Frequenzwert ermittelt wird, ein anderer von einem Spannungssignalkanal, einem Stromsignalkanal und einem optischen Signalkanal ist.

4. Verfahren nach einem der Ansprüche 1 - 3, wobei bei jeder Iteration, die Schritte (d), (e) und (g) mehr als einmal durchgeführt werden, sodass eine Vielzahl an weiteren Frequenzwerten im Schritt (d) ermittelt wird, wobei jeder eine Harmonische der ersten Frequenz F darstellt, die innerhalb eines Signalkanals vom Plasmasystem auftritt, und wobei für jede solcher Harmonischen eine entsprechende weitere komplexe Frequenzbereichskomponente im Schritt (e) bestimmt wird, die im Schritt (g) transformiert wird, um eine entsprechende phasenverstellte weitere komplexe Signalkomponente bereitzustellen, und wobei Schritt (i) separat für jede solche phasenverstellte weitere komplexe Signalkomponente wiederholt wird.

5. Verfahren nach Anspruch 4, wobei bei jeder Iteration, die Schritte (d), (e) und (g) mindestens einmal für einen weiteren Frequenzwert, der bei der ersten HF-Signalabtastung ermittelt wird, und mindestens einmal für einen weiteren Frequenzwert durchgeführt werden, der bei einer weiteren HF-Signalabtastung von einem anderen Signalkanal ermittelt wird.

6. Verfahren nach Anspruch 5, wobei der erste Frequenzwert als eine Grundfrequenz bei einem Spannungssignalkanal ermittelt wird, und wobei mindestens ein weiterer Frequenzwert eine Harmonische N > 1-ter Ordnung der Grundfrequenz bei dem Spannungssignalkanal ist, und wobei ein anderer der weiteren Frequenzwerte als eine Harmonische (N >= 1) derselben Grundfrequenz innerhalb einer Signalabtastung von einem Stromsignalkanal oder einem optischen Signalkanal ermittelt wird.

7. Verfahren nach Anspruch 5, wobei der erste Frequenzwert als eine Grundfrequenz bei einem Stromsignalkanal ermittelt wird, und wobei mindestens ein weiterer Frequenzwert eine Harmonische N > 1-ter Ordnung der Grundfrequenz beim Stromsignalkanal ist, und wobei ferner ein anderer der weiteren Frequenzwerte als eine Harmonische (N >= 1) derselben Grundfrequenz innerhalb einer Signalabtastung von einem Spannungssignalkanal oder einem optischen Signalkanal ermittelt wird.

8. Verfahren nach Anspruch 6 oder 7, wobei der erste Frequenzwert und die Vielzahl an weiteren Frequenzwerten mindestens die Harmonischen erster und zweiter Ordnung von einem Stromsignalkanal und die Harmonischen erster und zweiter Ordnung von einem Spannungssignalkanal einschließen.

9. Verfahren nach einem der vorhergehenden Ansprüche, wobei:
der Schritt (b) des Ermittelns eines ersten Frequenzwertes das Ermitteln einer Bin-Nummer *b1* einer diskreten Fourier-Transformation umfasst, bei der ein lokales Maximum der Signalamplitude lokalisiert oder erwartet wird, und
der Schritt (d) des Ermittelns eines weiteren Frequenzwertes das Bestimmen der Identität einer Bin-Nummer *b2* = N x *b1,* die der Modulo-Arithmetik unterliegt, wobei das Modulo die Gesamtanzahl von Bins ist, und das Auswählen einer Bin umfasst, die innerhalb von N Bins neben Bin *b2* liegt.

10. Verfahren nach Anspruch 9, wobei die Auswahl einer Bin, die innerhalb von N Bins neben Bin *b2* liegt, das Ermitteln einer Bin innerhalb des Bereichs umfasst, in dem ein lokales Maximum der Signalamplitude auftritt.

11. Verfahren nach Anspruch 9, wobei die Auswahl einer Bin, die innerhalb von N Bins neben Bin *b2* liegt, das Auswählen einer Bin umfasst, bei der ein Frequenzvielfaches F(N) auftreten wird, bei dem die Frequenz F mit einer Genauigkeit bekannt ist, die größer ist als die Bin-Größe.

12. Verfahren nach einem der vorhergehenden Ansprüche, wobei der Wert der ersten Frequenz F zwischen aufeinanderfolgenden Iterationen abweicht, und wobei bei jeder Iteration der erste Frequenzwert F als ein lokales Maximalsignal innerhalb eines erwarteten Frequenzbereichs ermittelt wird.

13. Verfahren nach einem der vorhergehenden Ansprüche, das ferner die Anfangsschritte des Empfangens von mindestens einer HF-Signalabtastung von einem Signalkanal und das Ausführen einer Transformation der mindestens einen HF-Signalabtastung zum Frequenzbereich umfasst.

14. Verfahren nach Anspruch 13, wobei die Transformation eine diskrete Fourier-Transformation und vorzugsweise eine schnelle Fourier-Transformation ist.

15. Verfahren nach einem der vorhergehenden Ansprüche, wobei die Schritte (b) bis (j) basierend auf einer verschiedenen ersten Frequenz F' wiederholt werden, bei der ein lokales Maximum im Frequenzbereich auftritt, bei dem F' und F keine Harmonischen voneinander sind.

16. Computerprogrammprodukt, das maschinenlesbare Anweisungen umfasst, die, wenn sie in einem Prozessor ausgeführt werden, dem Daten, die ein oder mehrere HF-Signale eines Plasmasystems darstellen, bereitgestellt werden, wirksam sind, um das Verfahren nach einem der Ansprüche 1 - 15 durchzuführen.

17. System zum Analysieren von HF-Signalen in einem Plasmasystem, das eine oder mehrere Verarbeitungsschaltungen umfasst, die programmiert sind, das Verfahren nach einem der Ansprüche 1 - 15 auszuführen.

18. System nach Anspruch 16, wobei die eine oder mehreren Verarbeitungsschaltungen als eine feldprogrammierbare Gatteranordnung implementiert sind, und wobei das Programmieren der Schaltungen das Konfigurieren der feldprogrammierbaren Gatteranordnung mit einer Logikfunktion umfasst, die das Verfahren implementiert.

## Revendications

1. Procédé d'analyse de signaux RF provenant d'un système plasma, comprenant les étapes :
(a) de réception en provenance du système plasma d'une ou plusieurs voies de signalisation, dans lequel la ou chaque voie de signalisation comprend une source de données représentant des signaux et du bruit provenant du système plasma sur une plage de fréquences ;
(b) d'identification, dans un premier échantillon de signal RF provenant de ladite ou desdites voies de signalisation, d'une première valeur de fréquence, F, à laquelle un maximum local est trouvé dans le domaine des fréquences ;
(c) de détermination d'une première composante de signal dans le domaine des fréquences complexe à ladite première valeur de fréquence F dans ledit premier échantillon de signal ;
(d) d'identification, dans ledit premier échantillon de signal RF ou dans un échantillon de signal RF supplémentaire provenant de l'une de ladite ou desdites voies de signalisation, d'une valeur de fréquence F(N) supplémentaire, où N est un nombre entier représentant une harmonique de N^{ième} ordre de ladite première fréquence F, et dans lequel N = 1 indique une harmonique de premier ordre à la première fréquence F ;
(e) de détermination d'une composante dans le domaine des fréquences complexe supplémentaire à ladite valeur de fréquence supplémentaire dans l'échantillon de signal RF dans lequel ladite valeur de fréquence supplémentaire est identifiée ;
(f) de transformation de la première composante dans le domaine des fréquences complexe en ajustant sa phase d'un angle θ à un angle de phase prédéterminé ϕ, pour fournir une première composante de signal complexe à phase ajustée ;
(g) de transformation de la composante de domaine des fréquences complexe supplémentaire en ajustant sa phase d'un angle égal à N x θ, pour fournir une composante de signal complexe supplémentaire à phase ajustée ;
(h) de répétition itérative des étapes (b) à (g) par rapport à une pluralité d'échantillons de signal provenant du même système plasma, dans lequel dans chaque itération, la valeur de θ est choisie pour donner un angle de phase constant ϕ pour la première composante de signal complexe à phase ajustée sur des itérations différentes, et dans lequel dans toute itération, la valeur de θ choisie à l'étape (f) est employée dans l'ajustement de l'étape (g) ;
(i) d'agrégation ou calcul de moyenne des premières composantes de signal complexes à phase ajustée obtenues dans chaque itération ;
(j) d'agrégation ou calcul de moyenne des composantes de signal complexes supplémentaires à phase ajustée obtenues dans chaque itération.

2. Procédé selon la revendication 1, dans lequel la voie de signalisation dans laquelle la première valeur de fréquence est identifiée n'est pas la même que la voie de signalisation dans laquelle la valeur de fréquence supplémentaire est identifiée.

3. Procédé selon la revendication 1 ou 2, dans lequel la voie de signalisation dans laquelle la première valeur de fréquence est sélectionnée est l'une parmi une voie de signalisation de tension, une voie de signalisation de courant, et une voie de signalisation optique, et la voie de signalisation dans laquelle la valeur de fréquence supplémentaire est identifiée est une voie différente parmi une voie de signalisation de tension, une voie de signalisation de courant, et une voie de signalisation optique.

4. Procédé selon l'une quelconque des revendications 1 à 3, dans lequel sur chaque itération, les étapes (d), (e) et (g) sont réalisées plus d'une fois pour qu'une pluralité de valeurs de fréquence supplémentaires soit identifiées à l'étape (d) représentant chacune une harmonique de ladite première fréquence F trouvée dans une voie de signalisation provenant du système plasma, et pour chacune de ces harmoniques, une composante dans le domaine des fréquences complexe supplémentaire respective est déterminée à l'étape (e) qui est transformée en étape (g) pour fournir une composante de signal complexe supplémentaire à phase ajustée respective, et dans lequel l'étape (i) est répétée séparément pour chacune de ces composantes de signal complexes supplémentaires à phase ajustée.

5. Procédé selon la revendication 4, dans lequel sur chaque itération, les étapes (d), (e) et (g) sont réalisées au moins une fois pour une valeur de fréquence supplémentaire identifiée dans ledit premier échantillon de signal RF, et au moins une fois pour une valeur de fréquence supplémentaire identifiée dans un échantillon de signal RF supplémentaire provenant d'une voie de signalisation différente.

6. Procédé selon la revendication 5, dans lequel la première valeur de fréquence est identifiée en tant que fréquence fondamentale dans une voie de signalisation de tension et dans lequel au moins une valeur de fréquence supplémentaire est une harmonique de ladite fréquence fondamentale dans ladite voie de signalisation de tension d'ordre N > 1, et en outre dans lequel une autre desdites valeurs de fréquence supplémentaires est identifiée en tant qu'harmonique (N >= 1) de la même fréquence fondamentale dans un échantillon de signal provenant d'une voie de signalisation de courant ou d'une voie de signalisation optique.

7. Procédé selon la revendication 5, dans lequel la première valeur de fréquence est identifiée en tant que fréquence fondamentale dans une voie de signalisation de courant et dans lequel au moins une valeur de fréquence supplémentaire est une harmonique de ladite fréquence fondamentale dans ladite voie de signalisation de courant d'ordre N > 1, et en outre dans lequel une autre desdites valeurs de fréquence supplémentaires est identifiée en tant qu'harmonique (N >= 1) de la même fréquence fondamentale dans un échantillon de signal provenant d'une voie de signalisation de tension ou d'une voie de signalisation optique.

8. Procédé selon la revendication 6 ou 7, dans lequel la première valeur de fréquence et une pluralité de valeurs de fréquence supplémentaires comportent au moins les harmoniques de premier et second ordres provenant d'une voie de signalisation de courant et les harmoniques de premier et second ordres provenant d'une voie de signalisation de tension.

9. Procédé selon une quelconque revendication précédente, dans lequel :
l'étape (b) d'identification d'une première valeur de fréquence comprend l'identification d'un numéro d'emplacement *b1* d'une transformée de Fourier discrète dans lequel un maximum local de grandeur de signal est localisé ou prévu, et
l'étape (d) d'identification d'une valeur de fréquence supplémentaire comprend la détermination de l'identité d'un numéro d'emplacement *b2 =* N x *b1,* sous réserve d'une arithmétique modulo où le module est le nombre total d'emplacements, et la sélection d'un emplacement qui se trouve à moins de N emplacements adjacents à l'emplacement *b2*.

10. Procédé selon la revendication 9, dans lequel la sélection d'un emplacement qui se trouve à moins de N emplacements adjacents à l'emplacement *b2* comprend l'identification d'un emplacement dans ladite plage où un maximum local de grandeur de signal est trouvé.

11. Procédé selon la revendication 9, dans lequel la sélection d'un emplacement qui se trouve à moins de N emplacements adjacents à l'emplacement *b2* comprend la sélection d'un emplacement dans lequel un multiple de fréquence F(N) sera trouvé où la fréquence F est connue avec une précision supérieure à la taille d'emplacement.

12. Procédé selon une quelconque revendication précédente, dans lequel la valeur de la première fréquence F dérive entre des itérations successives et dans lequel sur chaque itération la première fréquence F est identifiée en tant que signal de maximum local dans une plage de fréquences prévue.

13. Procédé selon une quelconque revendication précédente, comprenant en outre les étapes initiales de réception d'au moins un échantillon de signal RF en provenance d'une voie de signalisation et de réalisation d'une transformée dudit au moins un échantillon de signal RF dans le domaine des fréquences.

14. Procédé selon la revendication 13, dans lequel ladite transformée est une transformée de Fourier discrète, et de préférence une transformée de Fourier rapide.

15. Procédé selon une quelconque revendication précédente, dans lequel les étapes (b) à (j) sont répétées sur la base d'une première fréquence F' différente, à laquelle un maximum local est trouvé dans le domaine des fréquences, où F' et F ne sont pas des harmoniques l'une de l'autre.

16. Produit de programme d'ordinateur comprenant des instructions lisibles par machine qui, lorsqu'elles sont exécutées dans un processeur pourvu de données représentatives d'un ou plusieurs signaux RF d'un système plasma, sont efficaces pour réaliser le procédé de l'une quelconque des revendications 1 à 15.

17. Système d'analyse de signaux RF provenant d'un système plasma, comprenant un ou plusieurs circuits de traitement programmés pour exécuter le procédé de l'une quelconque des revendications 1 à 15.

18. Système selon la revendication 16, dans lequel lesdits un ou plusieurs circuits de traitement sont implémentés sous la forme d'un réseau de portes programmables et dans lequel ladite programmation desdits circuits comprend la configuration dudit réseau de portes programmables avec une fonction logique implémentant ledit procédé.
